# DEMANDE DE BREVET EUROPEEN

(11) **EP 0 991 122 A2**
(43) Date de publication de la demande: **05.04.2000**
(21) Numéro de dépôt: 99123564.9
(22) Date de dépôt: 05.04.1996
(51) Int. Cl.: H01L 23/495, C22C 38/10

(54) **Pattes de connexion pour composant electronique**

(30) Priorité: 27.04.1995 FR 9505015
(62) Demande divisionnaire de: 96400735.5
(71) Demandeur: IMPHY UGINE PRECISION, 92800 Puteaux (FR)
(72) Inventeur: Cozar, Ricardo, 58160 La Fermete (FR); Reyal, Jean-Pierre, 95610 Eragny (FR)
(74) Mandataire: Ventavoli, Roger

(57) **Abrégé**

Utilisation d'un alliage conducteur à durcissement structural pour la fabrication des pattes de connexion d'un composant électronique du type comprenant notamment un dispositif électronique, une pluralité de pattes de connexion et une enveloppe, l'alliage à durcissement structural étant de type austénitique et sa composition comprenant, en poids : 35% ≤ Co ≤ 55% ; 15% ≤ Cr ≤ 25% ; 10% ≤ Ni ≤ 35% ; 0% ≤ Fe ≤ 20% ; 0% ≤ Mo ≤ 10% ; 0% ≤ W ≤ 15% ; 0% ≤ Mn ≤ 2% ; 0% ≤ C ≤ 0,15% ; le reste étant des impuretés résultant de l'élaboration.Composant électronique et procédé pour fabriquer le composant électronique.

## Description

La présente invention concerne les pattes de connexion pour composants électroniques.

Certains composants électroniques, notamment les circuits intégrés et les composants discrets actifs, sont constitués d'un dispositif électronique, par exemple en matériau semi-conducteur, relié par des fils très fins à des pattes de connexion, l'ensemble étant enchâssé dans un boîtier de protection en matériau synthétique. Les pattes de connexion, qui débouchent à l'extérieur du boîtier, comportent une partie dite "pattes de connexion internes" située à l'intérieur du boîtier, et une partie dite "pattes de connexion externes", située à l'extérieur du boîtier. Les pattes de connexion externes sont destinées à relier le composant électronique au circuit imprimé auquel il est incorporé. Les pattes de connexion sont constituées soit d'un alliage du type fer-nickel à environ 42% de nickel, soit d'un alliage à base de cuivre. Le choix de l'alliage utilisé se fait, notamment, en fonction des propriétés électriques et mécaniques recherchées.

Pour fabriquer les pattes de connexion, on prend une bande d'alliage dans laquelle on découpe, soit par un moyen mécanique, soit par un moyen chimique, une ébauche, communément appelée "lead-frame", constituée d'une pluralité de pattes de connexion internes et externes, reliées entre elles par des bandes de métal, et disposées les unes par rapport aux autres comme elles le seront lorsqu'elles seront intégrées au composant électronique. L'ébauche est alors dégraissée, décapée, rincée, revêtue d'un dépôt galvanique de nickel puis d'un métal précieux ou de cuivre, avant assemblage et interconnexion avec le dispositif en matériau semi-conducteur qui est soudé ou collé sur une pièce métallique située au centre des pattes de connexion internes. Puis, l'ensemble ainsi obtenu est surmoulé par injection sous pression d'un polymère, et les pattes de connexion externes sont isolées les unes des autres par découpage. Les pattes de connexion externes sont alors décapées, étamées, puis, mises en forme par pliage. Le composant électronique est dit "encapsulé dans un boîtier plastique".

Ce procédé d'encapsulation est aussi utilisé pour les composants passifs tels que, par exemple, les inductances, les réseaux resistifs, les lignes à retard ou les capacités.

Pour connecter les dispositifs électroniques, on peut également utiliser le procédé appelé communément "transfert automatique sur bande" ou TAB dans lequel l'ébauche est fabriquée à partir d'un film de polyimide revêtu d'alliage de cuivre déposé par dépôt galvanique ou par colaminage.

Ces deux procédés présentent des inconvénients qui résultent de l'insuffisance des caractéristiques mécaniques des alliages utilisés. En particulier, avec le premier procédé, qui utilise des feuillards laminés, il est difficile de réduire l'épaisseur des pattes de connexion en dessous de 0,1 mm ce qui limite la miniaturisation des composants.

Avec le deuxième procédé, qui utilise des dépôts sur film de polyimide, la longueur des pattes de connexion internes ne peut pas être augmentée autant que cela serait souhaitable pour faciliter le montage.

Dans les deux cas, il n'existe pas de moyen connu pour satisfaire à la fois les contraintes de fabrication, et notamment l'aptitude à la mise en forme, et les exigences de résistance mécanique des pattes de connexion. De ce fait, et par exemple, il est difficile de fabriquer des circuits intégrés d'épaisseur inférieure à 1 mm, alors que pour certaines application, il serait souhaitable de pouvoir fabriquer des circuit intégrés d'épaisseur inférieure à 0,5 mm avec de bons rendements de fabrication

De plus, les composants électroniques constitués d'un dispositif encapsulé dans des boîtiers d'épaisseur inférieure à 0,5 mm sont très difficiles à manipuler du fait de la très grande fragilité des pattes de connexion externes.

Le but de la présente invention est de remédier à cet inconvénient en proposant un moyen pour fabriquer des pattes de connexion d'épaisseur inférieure à 0,1 mm pour composant électronique, ayant une résistance mécanique suffisante pour permettre la manipulation aisée du composant électronique et son montage sur un circuit imprimé.

A cet effet, l'invention a pour objet l'utilisation d'un alliage conducteur à durcissement structural pour la fabrication des pattes de connexion d'un composant électronique du type comprenant notamment un dispositif électronique, une pluralité de pattes de connexion et une enveloppe, l'alliage à durcissement structural étant découpé avant traitement de durcissement structural. Ce découpage, destiné à obtenir une ébauche de pattes de connexion, peut être réalisé soit par découpe mécanique, soit par découpe chimique.

L'alliage conducteur à durcissement structural est un alliage du type austénitique dont la composition chimique comprend, en poids,
35% ≤ Co ≤ 55%
15% ≤ Cr ≤ 25%
10% ≤ Ni ≤ 35%
0% ≤ Fe ≤ 20%
0% ≤ Mo ≤ 10%
0% ≤ W ≤ 15%
0% ≤ Mn ≤ 2%
0% ≤ C ≤ 0,15%
le reste étant des impuretés résultant de l'élaboration.

De préférence, la composition chimique de l'alliage conducteur à durcissement structural du type austénitique est telle que :
39% ≤ Co ≤ 41%
15% ≤ Fe ≤ 20%
15% ≤ Ni ≤ 17%
6% ≤ Mo ≤ 8%
19% ≤ Cr ≤ 21%

L'invention concerne aussi un composant électronique du type comprenant, notamment, un dispositif en matériau semi-conducteur, une pluralité de pattes de connexion et une enveloppe, dont les pattes de connexion sont constituées d'un alliage conducteur à durcissement structural du type austénitique dont la composition chimique comprend, en poids,
35% ≤ Co ≤ 55%
15% ≤ Cr ≤ 25%
10% ≤ Ni ≤ 35%
0% ≤ Fe ≤ 20%
0% ≤ Mo ≤ 10%
0% ≤ W ≤ 15%
0% ≤ Mn ≤ 2%
0% ≤ C ≤ 0,15%
le reste étant des impuretés résultant de l'élaboration.

De préférence, la composition chimique de l'alliage conducteur à durcissement structural de type austénitique est telle que :
39% ≤ Co ≤ 41%
15% ≤ Fe ≤ 20%
15% ≤ Ni ≤ 17%
6% ≤ Mo ≤ 8%
19% ≤ Cr ≤ 21%

Les pattes de connexion du composant selon l'invention peuvent avoir une épaisseur inférieure à 0,1 mm.

L'invention concerne également un procédé de fabrication d'un composant électronique du type comprenant, notamment, un dispositif électronique, une pluralité de pattes de connexion et une enveloppe, selon lequel :
- on fabrique une ébauche de pattes de connexion en un alliage conducteur à durcissement structural de type austénitique, avant durcissement structural,
- on forme les pattes de connexion, internes ou externes,
- on effectue un traitement thermique de durcissement secondaire,
- on fixe le dispositif électronique sur les pattes de connexion internes,
- on réalise l'enveloppe par surmoulage,
- et on coupe les pattes de connexion externes.

Le procédé de fabrication d'un composant électronique selon l'invention peut également être tel que :
- on fabrique une ébauche de pattes de connexion en un alliage conducteur à durcissement structural de type austénitique, avant durcissement structural,
- on fixe le dispositif électronique sur l'ébauche des pattes de connexion internes,
- on réalise l'enveloppe par surmoulage,
- on coupe les pattes de connexion externes,
- on forme les pattes de connexion externes,
- et on effectue un traitement thermique de durcissement secondaire localisé sur les pattes de connexion externes.

L'invention concerne enfin un procédé de fabrication d'un composant électronique par transfert automatique sur bande qui utilise une bande comportant au moins une couche en alliage conducteur à durcissement structural de type austénitique et, éventuellement, une couche de polymère pour la fabrication des ébauches des pattes de connexion

L'invention va maintenant être décrite de façon plus précise, mais non limitative, en prenant comme exemple de composant électronique un microprocesseur constitué d'une pastille en silicium dopé sur la quelle les circuits du microprocesseur sont implantés.

Dans un premier mode de réalisation, les circuits du microprocesseur sont reliés à des pattes de connexion internes par l'intermédiaire de fils d'or ou d'aluminium d'environ 30 µm de diamètre. Le tout est encapsulé dans une enveloppe constituée d'un boîtier en polymère du type époxy chargé de particules de silice ou d'autres matériaux isolants. Les pattes de connexion externes sortent à l'extérieure du boîtier et sont conformées de façon à pouvoir être soudées sur un circuit imprimé.

Les pattes de connexion internes et externes sont constituées d'un alliage conducteur à durcissement structural de type austénitique de limite d'élasticité supérieure à 1500 MPa après durcissement structural, dont la composition chimique, en poids, comprend:
35% ≤ Co ≤ 55%
15% ≤ Cr ≤ 25%
10% ≤ Ni ≤ 35%
0% ≤ Fe ≤ 20%
0% ≤ Mo ≤ 10%
0% ≤ W ≤ 15%
0% ≤ Mn ≤ 2%
0% ≤ C ≤ 0,15%
le reste étant des impuretés résultant de l'élaboration. Un tel alliage conducteur à durcissement structural est amagnétique et inoxydable, ce qui présente des avantages pour certaines applications.

De préférence, la composition chimique de l'alliage austénitique à durcissement structural est telle que :
39% ≤ Co ≤ 41%
15% ≤ Fe ≤ 20%
15% ≤ Ni ≤ 17%
6% ≤ Mo ≤ 8%
19% ≤ Cr ≤ 21%

Les pattes de connexion sont, éventuellement revêtues d'un dépôt galvanique de nickel puis d'or, d'argent ou de palladium, et leurs parties externes peuvent êtres étamées ou comporter un dépôt de brasure.

Pour fabriquer le composant électronique, on approvisionne un feuillard en alliage conducteur à durcissement structural d'épaisseur inférieure à 0,1 mm et de préférence comprise entre 30µm et 80µm, adouci par un traitement thermique à une température comprise entre 750°C et 1000°C pour avoir une limite d'élasticité inférieure à 1300 MPa, et on fabrique une ébauche de pattes de connexion.

L'ébauche de pattes de connexion ou "lead-frame", connue en elle même, est constituée d'une plaque rectangulaire comportant une pluralité de découpes destinées chacune à recevoir une pastille de silicium. Chaque découpe comporte une pluralité de lamelles attachées par une de leurs extrémités à la plaque, et disposées, les unes par rapport aux autres, de façon généralement rayonnante, et convergeant vers une même zone dans laquelle se trouve une plaquette rectangulaire sur laquelle sera implantée la pastille de silicium. Chacune des lamelles est destinée à constituer une patte de connexion. La partie d'une lamelle située à proximité de la zone de convergence est destinée à former une patte de connexion interne, et l'autre partie de la lamelle est destinée à former une patte de connexion externe. Les découpes sont réalisées par découpe mécanique ou par découpe chimique.

En général, on effectue les découpes sur le feuillard, et après découpe, on effectue successivement, un dégraissage anodique ou cathodique, un décapage chimique et un rinçage. On effectue alors un dépôt galvanique de nickel, puis un dépôt galvanique soit d'or, soit d'argent, soit de cuivre, soit de palladium. Enfin, on découpe les ébauches rectangulaires capables de recevoir cinq à douze pastilles de silicium.

Une fois les ébauches découpées, on forme les pattes de connexion par pliage ou emboutissage, et on effectue un traitement thermique de durcissement, par exemple par chauffage entre 400°C et 550°C pendant 1 à 5 heures, de préférence sous atmosphère neutre. Le traitement thermique peut également consister en un chauffage à une température de l'ordre de 700°C pendant quelques secondes à quelques minutes. Le formage des pattes peut également être effectué pendant l'opération de découpage, le traitement thermique est alors effectué après l'opération de découpage/formage.

On dispose alors sur chacune des plaquettes rectangulaires situées au centre de chacune des zones de convergence des lamelles, une pastille de silicium sur laquelle est implanté un circuit, qu'on soude ou qu'on colle. Puis, on connecte le circuit aux lamelles par des fils d'or ou d'aluminium.

Une fois les pastilles de silicium connectées aux lamelles, on réalise l'enveloppe de chacune des pastilles par surmoulage par injection sous pression d'un polymère, et on cuit l'ensemble entre 170°C et 250°C pendant 4 à 16 heures.

L'encapsulage terminé, on découpe l'ébauche autour de chacune des enveloppes, à une certaine distance de celle ci, de façon à laisser libre une certaine longueur de lamelle à l'extérieur de l'enveloppe, et on enlève la résine qui reste en excès entre les lamelles. On obtient, ainsi, un boîtier dans lequel est encapsulé un circuit intégré, et du quel sortent des pattes de connexion externes.

On effectue alors un décapage nitrique et un rinçage puis, on termine la fabrication des pattes de connexion externes soit par étamage, soit en réalisant un dépôt de brasure.

On obtient ainsi un composant électronique comportant des pattes de connexion d'épaisseur inférieure à 0,1 mm et de limite d'élasticité supérieure à 1500 MPa.

Au lieu d'effectuer le formage des pattes de connexion avant d'implanter les pastilles de silicium sur les ébauches de pattes de connexion, on peut implanter les pastilles de silicium, surmouler les boîtiers, découper les pattes de connexion autour des boîtiers, puis former par pliage les pattes de connexion externes et les durcir par un traitement thermique localisé effectué, par exemple, par laser.

Un deuxième mode de réalisation correspond à un procédé de fabrication de composants électronique dans le quel les ébauches de pattes de connexion sont disposées sur des rubans qui permettent une fabrication en série commode. Ce procédé est connu sous le nom de " TAB "ou " transfert automatique sur bande ".

Dans ce second mode de réalisation, on fabrique, par exemple par colaminage, un ruban constitué d'une couche de polymère tel qu'un polyimide, et d'une couche d'alliage conducteur à durcissement structural tel que défini ci dessus. Puis, par exemple par gravure chimique, on découpe dans la couche d'alliage des ébauches de pattes de connexion disposées les unes derrière les autres. On forme les pattes de connexion et on les durcit par traitement thermique comme ci-dessus. On peut, soit former les pattes de connexion avant d'effectuer le traitement thermique de durcissement, soit faire d'abord le traitement thermique de durcissement puis former les pattes de connexion.

De façon connue en soi, on vient disposer un dispositif électronique constitué, par exemple, d'une pastille de silicium portant un circuit intégré, sous chacune des ébauches de pattes de connexion, et on soude les pattes de connexion internes sur le dispositif électronique. Les circuits ainsi réalisés peuvent alors êtres reportés automatiquement sur un circuit électronique, par exemple un circuit imprimé, à l'aide d'une machine spécialisée qui coupe les pattes de connexion externes et les connecte par brasage au circuit imprimé.

L'utilisation d'un alliage selon l'invention a l'avantage de permettre la réalisation de pattes de connexion internes plus longues d'au moins 15% par rapport à ce que permet la technique selon l'art antérieur.

Les alliages selon l'invention ayant des caractéristiques mécaniques très élevées, il est possible de mettre en oeuvre le procédé TAB avec des bandes constituées uniquement de l'alliage conducteur à durcissement structural, c'est à dire, sans couche de polymère.

Avec les procédés selon l'invention, on a fabriqué des composants électroniques constitués d'une pastille de silicium contenue dans une enveloppe en résine et comportant des pattes de connexion en alliage conducteur à durcissement structural. L'épaisseur totale des composants était inférieure à 1 mm, et l'épaisseur des pattes de connexion étaient inférieure à 0,1 mm, et, par exemple, d'épaisseur comprise entre 0,03 mm et 0,08 mm. Ces composants électroniques pour montage en surface, ont des pattes de connexion moins fragiles que celles de l'art antérieur.

D'une façon générale, les alliages conducteurs à durcissement structural peuvent êtres utilisés pour la fabrication de composants actifs discrets et de composants passifs, notamment d'inductances, de réseaux résistifs ou de capacités, pour montage en surface.

## Revendications

1. Utilisation d'un alliage conducteur à durcissement structural pour la fabrication des pattes de connexion d'un composant électronique du type comprenant notamment un dispositif électronique, une pluralité de pattes de connexion et une enveloppe, caractérisée en ce que l'alliage à durcissement structural est de type austénitique et en ce que sa composition comprend, en poids :
35% ≤ Co ≤ 55%
15% ≤ Cr ≤ 25%
10% ≤ Ni ≤ 35%
0% ≤ Fe ≤ 20%
0% ≤ Mo ≤ 10%
0% ≤ W ≤ 15%
0% ≤ Mn ≤ 2%
0% ≤ C ≤ 0,15%
le reste étant des impuretés résultant de l'élaboration.

2. Utilisation d'un alliage conducteur à durcissement structural selon la revendication 1 caractérisée en ce que la composition chimique de l'alliage conducteur à durcissement structural est telle que :
39% ≤ Co ≤ 41%
15% ≤ Fe ≤ 20%
15% ≤ Ni ≤ 17%
6% ≤ Mo ≤ 8%
19% ≤ Cr ≤ 21%

3. Composant électronique du type comprenant notamment un dispositif en matériau semi-conducteur, une pluralité de pattes de connexion et une enveloppe, caractérisé en ce que les pattes de connexion sont constituées d'un alliage conducteur à durcissement structural du type austénitique dont la composition chimique comprend, en poids :
35% ≤ Co ≤ 55%
15% ≤ Cr ≤ 25%
10% ≤ Ni ≤ 35%
0% ≤ Fe ≤ 20%
0% ≤ Mo ≤ 10%
0% ≤ W ≤ 15%
0% ≤ Mn ≤ 2%
0% ≤ C ≤ 0,15%
le reste étant des impuretés résultant de l'élaboration.

4. Composant selon la revendication 3 caractérisé en ce que la composition chimique de l'alliage conducteur à durcissement structural est telle que :
39% ≤ Co ≤ 41%
15% ≤ Fe ≤ 20%
15% ≤ Ni ≤ 17%
6% ≤ Mo ≤ 8%
19% ≤ Cr ≤ 21%

5. Composant selon l'une quelconque des revendications 3 ou 4 caractérisé en ce que l'épaisseur des pattes de connexion est inférieure à 0,1 mm.

6. Procédé de fabrication d'un composant électronique selon l'une quelconque des revendications 3 à 5, caractérisé en ce que:
- on fabrique une ébauche de pattes de connexion, en un alliage conducteur à durcissement structural, avant durcissement structural,
- on forme les pattes de connexion, internes ou externes,
- on effectue un traitement thermique de durcissement secondaire,
- on fixe le dispositif électronique sur les pattes de connexion internes,
- on réalise l'enveloppe par surmoulage,
- et on coupe les pattes de connexion externes.

7. Procédé de fabrication d'un composant électronique selon l'une quelconque des revendications 3 à 5, caractérisé en ce que:
- on fabrique une ébauche de pattes de connexion, en un alliage conducteur à durcissement structural, avant durcissement structural,
- on fixe le dispositif électronique sur l'ébauche des pattes de connexion internes,
- on réalise l'enveloppe par surmoulage,
- on coupe les pattes de connexion externes,
- on forme les pattes de connexion externes,
- on effectue un traitement thermique de durcissement secondaire localisé sur les pattes de connexion externes.

8. Procédé de fabrication d'un composant électronique selon l'une quelconque des revendications 3 à 5, caractérisé en ce que:
- on approvisionne une bande comportant au moins une couche en alliage conducteur à durcissement structural, avant durcissement structural, et, éventuellement, une couche de polymère,
- on découpe dans la bande une ébauche de pattes de connexion,
- soit on forme les pattes de connexion et on effectue un traitement thermique de durcissement, soit on effectue un traitement thermique de durcissement et on forme les pattes de connexion,
- on connecte par soudage les pattes de connexion internes au dispositif électronique
- et on coupe puis on connecte par brasage les pattes de connexion externes au circuit imprimé.
